(19) **Europäisches Patentamt / European Patent Office / Office européen des brevets**

(11) **EP 3 109 653 B1**

(12) **EUROPÄISCHE PATENTSCHRIFT**

(45) Veröffentlichungstag und Bekanntmachung des Hinweises auf die Patenterteilung:
**27.04.2022   Patentblatt 2022/17**

(21) Anmeldenummer: **15173377.1**

(22) Anmeldetag: **23.06.2015**

(51) Internationale Patentklassifikation (IPC):
*G01R 31/3842* (2019.01)     *G01R 31/52* (2020.01)
*G01R 31/50* (2020.01)     *G01R 31/396* (2019.01)

(52) Gemeinsame Patentklassifikation (CPC):
**G01R 31/396; G01R 31/3842; G01R 31/50;**
**G01R 31/52;** G01R 31/389

(54) **VERFAHREN ZUM ERKENNEN EINES KURZSCHLUSSES INNERHALB EINES ENERGIESPEICHERS**

METHOD FOR DETECTION OF A SHORT CIRCUIT WITHIN AN ENERGY STORAGE DEVICE

PROCEDE DE RECONNAISSANCE D'UN COURT-CIRCUIT DANS UN ACCUMULATEUR D'ENERGIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**28.12.2016   Patentblatt 2016/52**

(73) Patentinhaber:
• **Robert Bosch GmbH**
**70442 Stuttgart (DE)**
• **GS Yuasa International Ltd.**
**Kisshoin, Minami-ku,**
**Kyoto-shi, Kyoto 601-8520 (JP)**

(72) Erfinder:
• **FRIEDRICH, Marco**
**71638 Ludwigsburg (DE)**

• **HEIL, Matthias**
**71696 Moeglingen (DE)**
• **BUTZMANN, Stefan**
**58579 Schalksmühle (DE)**
• **BERNHARDT, Christian**
**70327 Stuttgart (DE)**

(74) Vertreter: **Isarpatent**
**Patent- und Rechtsanwälte Barth**
**Charles Hassa Peckmann & Partner mbB**
**Postfach 44 01 51**
**80750 München (DE)**

(56) Entgegenhaltungen:
**EP-A2- 1 263 111     EP-A2- 2 073 031**
**DE-A1- 10 222 175     JP-A- 2001 110 457**

**Beschreibung**

Stand der Technik

Die vorliegende Erfindung betrifft ein Verfahren zum Erkennen eines Kurzschlusses innerhalb eines Energiespeichers.

Bei heute verwendeten elektrochemischen Energiespeichern, wie zum Beispiel Batteriezellen, können bei Auftreten von Zellfehlern unerwünschte, potenziell gefährliche Reaktionen des Energiespeichers erfolgen. Insbesondere stellen innerhalb des Energiespeichers auftretende elektrisch leitfähige Verbindungen, zum Beispiel innere Kurzschlüsse, Körperschlüsse oder Feinschlüsse, ein konkretes Gefährdungspotenzial dar, da es durch unerwünschten Stromfluss im Energiespeicher zu starker Erwärmung des Energiespeichers kommen kann. So kann es beispielsweise zu einer starken Erwärmung einzelner Batteriezellen oder mehrerer Batteriezellen in einem Batteriemodul kommen. Bedingt durch diese Erwärmung kann bei Überschreiten einer kritischen Temperatur, insbesondere einer Zelltemperatur, eine selbsterhaltende exotherme Reaktion einer Batteriezelle ausgelöst werden. Dies wird auch als ein thermal runaway bezeichnet. Fälle, in denen als Folge solcher Zellfehler ein Zellbrand und/oder eine Zellexplosion auftraten, sind bekannt.

Das Gefahrenpotenzial von elektrochemischen Primär- und Sekundärspeichern und die Auswirkungen im Fehlerfall auf Personen, Sachwerte und die Umwelt sind bekannt.

Die möglichen Gefährdungen durch elektrochemische Energiespeicher sind eine Herausforderung, insbesondere bei Energiespeichern für Elektromobilitätsanwendungen, wie zum Beispiel PKWs, LKWs oder Förderfahrzeuge, welche jeweils entweder mit vollelektrischem Antrieb oder elektrisch unterstütztem Antrieb ausgerüstet sind. Batteriesysteme in solchen Anwendungen müssen oft eine hohe Leistung und hohe gespeicherte Energie bereitstellen und haben dadurch bedingt ein hohes Gefährdungspotenzial. Gleichzeitig bestehen jedoch hohe Anforderungen an die Sicherheit des Energiespeichers, welche beim Entwurf des Batteriesystems berücksichtigt werden. Insbesondere für Hochleistungs- und Hochenergiezellen der oben genannten Anwendungsfälle ist es wünschenswert, auftretende Zellfehler möglichst früh und mit hoher Zuverlässigkeit zu erkennen, um gefährliche Situationen durch Warnung des Benutzers und/oder durch technische Gegenmaßnahmen zu vermeiden.

Heutige Batteriesysteme zur Anwendung in der Elektromobilität bestehen üblicherweise aus einer Reihenschaltung mehrere Batteriezellen. Die Batteriezellen werden dabei üblicherweise in Batteriemodulen zusammengefasst, welche mit einer Sensorik zur Zellüberwachung versehen sind. Mehrere Batteriemodule bilden ein Batteriesystem. Eine zentrale Steuereinheit des Batteriesystems fasst die Signale der Sensorik in den Batteriemodulen und weitere Sensorsignale zusammen und realisiert einfache Steueraktionen, wie zum Beispiel das vollständige Abschalten des Batteriesystems im Fehlerfall. Zellen in solchen Batteriesystemen sind oftmals Hochleistungs-/Hochenergiezellen in spezieller Bauform. Die spezielle Bauform zeichnet sich oftmals durch prismatische Gehäuse aus Aluminiumlegierungen oder Edelstahl aus. Derzeitig werden üblicherweise Lithiumionenzellen für die benannten Anwendungen verwendet.

Verfahren zum Erkennen eines Kurzschlusses sind aus der US2010/0188054, der US2010/0194398 und der US2011/0148426 bekannt.

JP 2001110457 A beschreibt ein Verfahren zur Feststellung eines anormalen Zustandes einer Batterie. Um anormale Zustände einer Sekundärbatterie frühzeitig zu erkennen wird unter anormalen Bedingungen bestimmt, wenn eine der folgenden Bedingungen erfüllt ist: Ladestrom über einen vorgeschriebenen Wert fließt und die Batteriespannung nahezu konstant ist, Ladestrom fließt und die Batteriespannung sinkt, der Ladestrom fließt und die Batteriespannung plötzlich ansteigt, die Batteriespannung in dem Zustand sinkt, in dem sowohl der Ladestrom als auch der Entladestrom nicht fließen, die Batteriespannung steigt in einem Zustand, in dem Ladestrom fließt oder sowohl der Ladestrom als auch der Entladestrom nicht fließen, die Batteriespannung sinkt plötzlich in dem Zustand, in dem der Ladestrom fließt oder sowohl der Ladestrom als auch der Entladestrom nicht fließen.

EP 1 263 111 A2 beschreibt ein Erfassungsverfahren zum Erfassen interner Informationen einer inspizierten wiederaufladbaren Batterie, wenn die inspizierte wiederaufladbare Batterie durch einen Konstantstrom-Konstantspannungs-Ladebetrieb geladen wird.

Offenbarung der Erfindung

Das erfindungsgemäße Verfahren zum Erkennen eines Kurzschlusses innerhalb eines Energiespeichers umfasst die Merkmale des Patentanspruchs 1. Somit wird es ermöglicht, einen plötzlich innerhalb des Energiespeichers auftretenden Kurzschluss besonders schnell und auf einfache Weise zu detektieren. Ein Kurzschluss kann dabei bereits dann erkannt werden, wenn nur eine sehr geringe, also sehr räumlich begrenzte, elektrisch leitfähige Verbindung zwischen einer Kathode und einer Anode des Energiespeichers auftritt. Die Unteransprüche zeigen bevorzugte Weiterbildungen der Erfindung.

Es ist vorteilhaft, wenn die Differenzspannung eine maximale Spannungsänderung ist, die sich aus einem maximalen Entladestrom des Energiespeichers ergibt. Auf diese Weise wird auch bei einem plötzlich ansteigenden Entladestrom gewährleistet, dass ein Kurzschluss zuverlässig erkannt wird, und es zu keiner Fehlerkennung kommt, die auf einem Abfall der zweiten Spannung aufgrund eines ansteigenden Entladestroms beruht.

Auch ist es vorteilhaft, wenn die Differenzspannung eine zu erwartende Spannungsänderung ist, die sich aus einem gemessenen Entladestrom des Energiespeichers ergibt. Somit kann besonders präzise zwischen einer zweiten Spannung, bei der ein Kurzschluss vorliegt, und einer zweiten Spannung, bei der kein Kurzschluss vorliegt, unterschieden werden. Somit wird es ermöglicht, den

Zeitraum zwischen dem Erfassen der ersten Spannung und dem Erfassen der zweiten Spannung besonders kurz zu wählen und somit ein sehr schnelles Erkennen eines Kurzschlusses zu ermöglichen.

Gemäß der Erfindung wird ein Innenwiderstand des Energiespeichers abgeschätzt und die Differenzspannung basierend auf dem Innenwiderstand ermittelt wird. Auf diese Weise kann das Verfahren an einen wechselnden Innenwiderstand des Energiespeichers angepasst werden. Somit können beispielsweise Fehlerkennungen unterbunden werden, die auf einer Temperaturschwankung des Energiespeichers beruhen.

Eine Vorrichtung, die dazu eingerichtet ist das erfindungsgemäße Verfahren auszuführen, weist alle Vorteile des erfindungsgemäßen Verfahrens aus.

Dabei ist es vorteilhaft, wenn die Vorrichtung einen Kondensator umfasst, durch den die ersten Spannung erfasst und vorgehalten wird. Auf diese Weise kann die erste Spannung besonders schnell erfasst werden und steht unmittelbar nach dem Erfassen für die in den Erkennungsschritten definierte Auswertung bereit. Ein Zeitintervall zwischen dem ersten Zeitpunkt und dem zweiten Zeitpunkt kann somit besonders gering gewählt werden, wodurch ein besonders schnelles Erkennen eines Kurzschlusses innerhalb des Energiespeichers ermöglicht wird. Auch ist es vorteilhaft, wenn die Vorrichtung eine Diode umfasst, die derart verschaltet ist, dass diese ein Aufladen des Kondensators mittels einer von dem Energiespeicher bereitgestellten Spannung ermöglicht, aber ein Entladen des Kondensators verhindert. Auf diese Weise wird sichergestellt, dass kein ungewolltes Entladen des Kondensators in eine an den Energiespeicher angeschlossene Last erfolgt, wodurch es zu einer Fehlerkennung kommen könnte.

Ebenfalls ist es vorteilhaft, wenn die Vorrichtung einen Schalter umfasst, über welchen der Kondensator trennbar mit einem Ausgang des Energiespeichers verbunden ist. Auf diese Weise kann der Kondensator, beziehungsweise die in diesem gespeicherte Spannung, entladen werden und die in dem Kondensator gespeichert Spannung einer Last zugeführt werden.

Kurze Beschreibung der Zeichnungen

Nachfolgend werden Ausführungsbeispiele der Erfindung unter Bezugnahme auf die begleitende Zeichnung im Detail beschrieben. In der Zeichnung ist:

Figur 1     ein Diagramm, welches einen Spannungsverlauf, einen Stromverlauf und einen Temperaturverlauf an einem Energiespeicher im Falle eines Kurzschlusses zeigt,

Figur 2     ein Ablaufdiagramm des erfindungsgemäßen Verfahrens in einer ersten Ausführungsform, und

Figur 3     eine Schaltung, welche von einer Vorrichtung umfasst wird, durch welche das erfindungsgemäße Verfahren in der ersten Ausführungsform ausgeführt wird.

Ausführungsformen der Erfindung

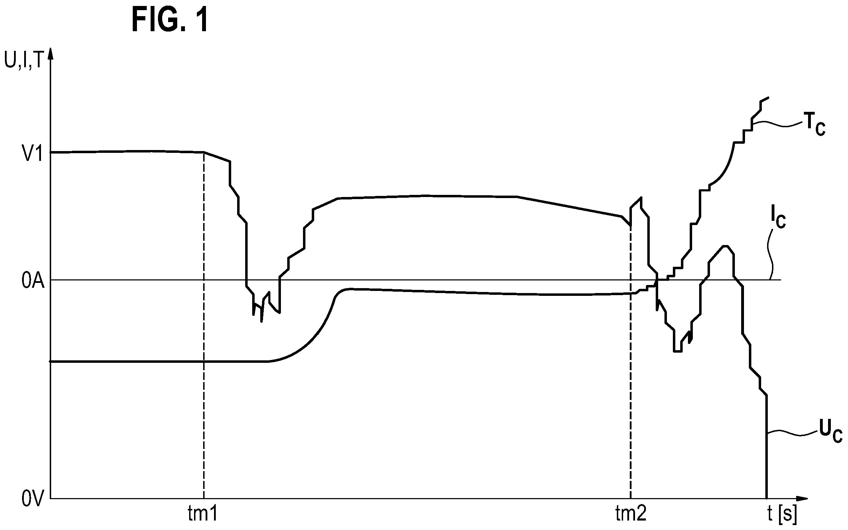

Figur 1 zeigt einen Spannungsverlauf, einen Stromverlauf und einen Temperaturverlauf eines Energiespeichers. Der Energiespeicher ist hierbei eine Batteriezelle 2. Der Stromverlauf zeigt daher einen Verlauf eines Zellstromes $I_C$ über die Zeit. Der Spannungsverlauf zeigt einen Verlauf einer Zellspannung $U_C$ über die Zeit. Der Temperaturverlauf zeigt einen Verlauf einer Zelltemperatur $T_C$ über die Zeit.

In dem in Figur 1 dargestellten Fall befindet sich der Energiespeicher in einem Leerlaufzustand. Der Zellstrom $I_C$ liegt daher konstant bei 0 Ampere. Die Zellspannung $U_C$ verläuft zunächst konstant auf dem Spannungswert einer Leerlaufspannung V1. Zu einem Kurzschlusszeitpunkt tm1 fällt die Zellspannung $U_C$ jedoch ab. Es ist ersichtlich, dass die Zellspannung $U_C$ nicht unmittelbar auf 0 Volt abfällt. Zunächst kommt es lediglich zu einem Anstieg der Zelltemperatur $T_C$, wobei sich die Zellspannung $U_C$ etwas erholt, jedoch weiterhin unter dem Spannungswert der Leerlaufspannung V1 verbleibt. Erst zu einem späteren Zeitpunkt tm2 bricht die Zellspannung $U_C$ vollständig ein und es kommt zu einem erneuten Anstieg der Zelltemperatur $T_C$, welcher durch ein thermisches Durchgehen der Batteriezelle 2 begründet ist.

In Figur 1 ist somit beispielhaft jeweils ein Verlauf des Zellstroms $I_C$ durch die Batteriezelle 2, der Zellspannung $U_C$ an den Zellterminals der Batteriezelle 2 und der Batterietemperatur $T_C$ der Batteriezelle 2 beim Auftreten interner Kurzschlüsse gezeigt. Im linken Teil der in Figur 1 dargestellten Kurven ist ein Spannungseinbruch durch plötzliches Auftreten eines internen Kurzschlusses erkennbar, welcher hier jedoch nur zu einer begrenzten Zunahme der Zelltemperatur $T_C$ führt, also noch nicht zu einem kritischen Zellverhalten. Die Zellspannung $U_C$ kehrt nach einigen Sekunden auf einen höheren Wert zurück. Im rechten Teil der in Figur 1 dargestellten Kurven sind erneut mehrfache Spannungseinbrüche gezeigt, welche hierzu einem kritischen Anstieg der Zelltemperatur $T_C$ und somit zu einem sogenannten Thermal Runaway der Batteriezelle 2 führen.

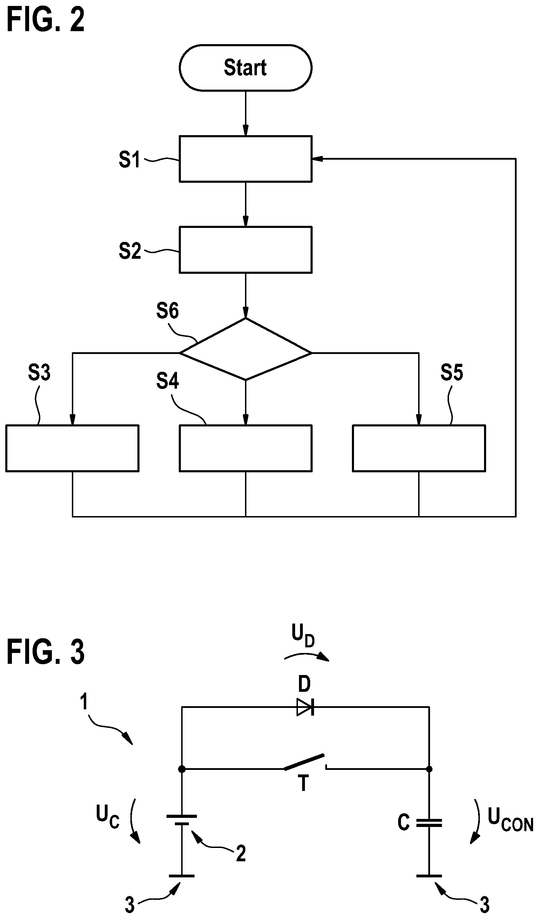

Figur 2 zeigt ein Ablaufdiagramm des erfindungsgemäßen Verfahrens in einer ersten Ausführungsform. Das Verfahren wird bei einer Inbetriebnahme der Batteriezelle 2 gestartet. Nach dem Start des Verfahrens wird ein erster Schritt S1 ausgeführt.

In dem ersten Schritt S1 erfolgt ein Erfassen des Zellstromes $I_C$, welcher durch den Energiespeicher fließt. Das Erfassen erfolgt beispielsweise mittels eines Stromsensors, welcher an einem Ausgang der Batteriezelle 2 angeordnet ist. Der Zellstrom $I_C$ wird dabei zu einem ersten Zeitpunkt erfasst und als ein Strommesswert gespeichert, welcher einen ersten Strom $I_{n-1}$ beschreibt. Der Zellstrom $I_C$ wird ferner zu einem zweiten Zeitpunkt erfasst und als ein Strommesswert gespeichert, welcher einen zweiten Strom $I_n$ beschreibt.

Ferner erfolgt in dem ersten Schritt S1 ein Erfassen einer ersten Spannung $U_{n-1}$, welche von dem Energiespeicher zu dem ersten Zeitpunkt n-1 bereitgestellt wird und ein Erfassen einer zweiten Spannung $U_n$, welche von dem Energiespeicher zu dem auf den ersten Zeitpunkt n-1 folgenden zweiten Zeitpunkt n bereitgestellt wird. Die ersten Spannung $U_{n-1}$ ist die Zellspannung $U_C$ zu dem ersten Zeitpunkt n-1. Die zweite Spannung $U_n$ ist die Zellspannung $U_C$ zu dem zweiten Zeitpunkt n. Der ersten Zeitpunkt n-1 und der zweite Zeitpunkt n sind dabei Zeitpunkte, die kurz aufeinanderfolgen. So könnte beispielsweise ein Zeitintervall zwischen dem ersten Zeitpunkt n-1 und dem zweiten Zeitpunkt n geringer als eine Sekunde sein. Das Erfassen der ersten Spannung $U_{n-1}$ und der zweiten Spannung $U_n$ erfolgt in dieser ersten Ausführungsform mittels eines Spannungssensors, welcher eine Spannung zwischen einem positiven Pol und einem negativen Pol der Batteriezelle 2 erfasst. Die erste Spannung $U_{n-1}$ und die zweite Spannung $U_n$ werden jeweils als ein Spannungsmesswert gespeichert.

Nach dem ersten Schritt S1 wird ein zweiter Schritt S2 ausgeführt.

In dem zweiten Schritt S2 erfolgt ein Feststellen, ob der Energiespeicher sich in einem Ladezustand, einem Entladezustand oder in einem Leerlaufzustand befindet. Dies erfolgt basierend auf dem erfassten ersten Strom $I_{n-1}$. Dabei wird festgestellt, dass sich der Energiespeicher in einem Ladezustand befindet, wenn der erste Strom $I_{n-1}$ kleiner als 0 Ampere ist. Es wird festgestellt, dass der Energiespeicher sich in einem Entladezustand befindet, wenn der erste Strom $I_{n-1}$ größer als 0 Ampere ist. Es wird festgestellt, dass der Energiespeicher sich in einem Leerlaufzustand befindet, wenn der erste Strom $I_{n-1}$ gleich 0 Ampere ist. Es sei vermerkt, dass das Feststellen, ob der Energiespeicher sich in einem Ladezustand, einem Entladezustand oder in einem Leerlaufzustand befindet, ebenfalls basierend auf dem erfassten zweiten Strom $I_n$ oder einem, zu einem anderen Zeitpunkt erfassten Zellstrom $I_C$ erfolgen kann.

Nach dem zweiten Schritt S2 wird ein erster Erkennungsschritt S3, ein zweiter Erkennungsschritt S4 oder ein dritter Erkennungsschritt S5 ausgeführt. Dazu wird in einem Entscheidungsschritt S6, welcher auf den zweiten Schritt S2 folgt, geprüft, ob der Ladezustand, der Entladezustand oder der Leerlaufzustand vorliegt und dementsprechend der erste Erkennungsschritt S3, der zweite Erkennungsschritt S4 oder der dritte Erkennungsschritt S5 aufgerufen und ausgeführt.

Befindet sich der Energiespeicher in einem Leerlaufzustand, was der Fall ist, wenn der erste Strom $I_{n-1}$ gleich 0 Ampere ist, so wird der erste Erkennungsschritt S3 ausgeführt. In dem ersten Erkennungsschritt S3 wird ein Kurzschluss als vorliegend erkannt, wenn die zweite Spannung $U_n$ kleiner als die erste Spannung $U_{n-1}$ abzüglich einer ersten Konstante $\varepsilon 1$ ist. Dies kann beispielsweise geprüft werden, indem die folgende erste Formel auf ihre Wahrheit hin geprüft wird.

$$U_n \leq U_{n-1} - \varepsilon 1 \quad (1)$$

Fließt kein Zellstrom durch die Batteriezelle 2, und ist der erste Strom $I_C$ somit gleich 0 Ampere, so ist zu erwarten, dass die Zellspannung $U_C$ der Batteriezelle 2, wenn kein Fehler vorliegt, abgesehen von einem leichten Absinken, welches durch eine Selbstentladung der Zelle verursacht wird, weitgehend konstant ist. Ein Batteriezellenfehler durch einen internen Kurzschluss wird erkannt, wenn ein Abfallen der Zellspannung $U_C$ gemessen wird, was hier durch einen Vergleich der Zellspannung $U_C$ zu dem ersten Zeitpunkt n-1, also der ersten Spannung $U_{n-1}$, und der Zellspannung $U_C$ zu dem zweiten Zeitpunkt n, also der zweiten Spannung $U_n$, erfolgt. Die erste Konstante $\varepsilon 1$ ist hierbei ein Spannungswert geringer Größe, der eine Empfindlichkeit bei dem Erkennen eines Kurzschlusses definiert. Es wird somit vermieden, dass eine Fehlerkennung eines Kurzschlusses aufgrund einer Messabweichung erfolgt. Der erste Zeitpunkt n-1 und der zweite Zeitpunkt n verweist auf eine Zeit im Allgemeinen, welches sowohl eine kontinuierliche Zeit als auch eine diskrete Zeit sein kann als auch Zeitwerte, die über einen Zeitbereich gemittelt werden.

Der zweite Erkennungsschritt S4 wird ausgeführt, wenn der Energiespeicher sich in einem Ladezustand befindet, also der erste Strom $I_{n-1}$ kleiner als 0 Ampere ist. In dem zweiten Erkennungsschritt S4 wird ein Kurzschluss als vorliegend erkannt, wenn die zweite Spannung $U_n$ kleiner als die erste Spannung $U_{n-1}$ abzüglich einer zweiten Konstanten $\varepsilon 2$ ist.

Während einem Laden der Batteriezelle 2 steigt die Zellspannung $U_C$ kontinuierlich an, so lange kein Fehler in der Batteriezelle 2 vorliegt. Ein Fehler in der Batteriezelle 2, wie er bei einem internen Kurzschluss vorliegt, wird daher erkannt, wenn die Zellspannung $U_C$ sinkt. Dies kann beispielsweise geprüft werden, indem die folgende zweite Formel auf ihre Wahrheit hin geprüft wird.

$$U_n \leq U_{n-1} - \varepsilon 2 \quad (2)$$

Die zweite Konstante $\varepsilon 2$ ist dabei gleich der ersten Konstanten $\varepsilon 1$ und dient ebenfalls dazu zu vermeiden, dass eine Fehlerkennung eines Kurzschlusses aufgrund einer Messabweichung erfolgt.

Der dritte Erkennungsschritt S5 wird ausgeführt, wenn der Energiespeicher sich in dem Entladezustand befindet, also der erste Strom $I_{n-1}$ größer 0 Ampere ist. Bei einem Entladen der Batteriezelle 2 treten auch Spannungsabfälle auf, die durch ein Ansteigen des Zellstromes $I_C$ verursacht sind, was beispielsweise bei einer Laständerung eintritt. Daher muss zwischen regulären Spannungsabfällen und Spannungsabfällen, die in einem Kurzschluss begründet sind, unterschieden werden. Dies muss mit hoher Zuverlässigkeit erfolgen.

Ein Kurzschluss wird als vorliegend erkannt, wenn die zweite Spannung $U_n$ kleiner als die ersten Spannung $U_{n-1}$ abzüglich einer Differenzspannung $\Delta U$ und abzüglich einer dritten Konstanten $\varepsilon 3$ ist. Dies kann beispielsweise geprüft werden, indem die folgende dritte Formel auf ihre Wahrheit hin geprüft wird.

$$U_n \leq U_{n-1} - \Delta U - \varepsilon 3 \qquad (3)$$

Die Differenzspannung $\Delta U$ ist in dieser Ausführungsform eine maximale Differenzspannung $\Delta U_{max}$. Die maximale Differenzspannung $\Delta U_{max}$ ergibt sich aus einer maximalen Änderung des Zellstroms $\Delta I_{max}$ und einem Innenwiderstand $R_C$ der Batteriezelle 2. Die maximalen Differenzspannung $\Delta U_{max}$ kann somit in einer vierten Formel beschrieben werden:

$$\Delta U_{max} = - \Delta I_{max} \cdot R_C \qquad (4)$$

Die maximalen Änderung des Zellstroms $\Delta I_{max}$ ist dabei ein Unterschied zwischen dem Zellstrom $I_C$ zu dem ersten Zeitpunkt n-1 gegenüber dem Zellstrom $I_C$ zu dem zweiten Zeitpunkt n. Der Zellstrom $I_C$ zu dem ersten Zeitpunkt n-1 ist der erste Strom $I_{n-1}$. Der Zellstrom $I_C$ zu dem zweiten Zeitpunkt n ist der zweiter Strom $I_n$. Die maximalen Änderung des Zellstroms $\Delta I_{max}$ kann somit in einer fünften Formel beschrieben werden:

$$\Delta I_{max} = I_n - I_{n-1} \qquad (5)$$

Die Differenzspannung $\Delta U$ ist somit in dieser Ausführungsform eine Differenzspannung, die sich aus einer Veränderung des Batteriestromes $I_C$ zwischen dem ersten Zeitpunkt n-1 und dem zweiten Zeitpunkt n ergibt. Die dritte Konstante $\varepsilon 3$ entspricht der ersten Konstante $\varepsilon 1$ und der zweiten Konstante $\varepsilon 2$.

Der Innenwiderstand $R_C$ ist eine sinnvolle Abschätzung des internen Widerstandes der Batteriezelle 2, welcher sich auch über die Zeit verändern kann und mittels eines beliebigen Verfahrens zum Bestimmen des Innenwiderstandes ermitteln lässt.

Da sowohl der erste Strom $I_{n-1}$ als auch der zweite Strom $I_n$ in dem zweiten Schritt S2 erfasst wurden, wird in dieser Ausführungsform die maximale Änderung des Zellstroms $\Delta I_{max}$ gemäß der fünften Formel errechnet. Basierend auf dieser wird gemäß der vierten Formel die maximale Differenzspannung $\Delta U_{max}$ berechnet. Diese berechnete maximale Differenzspannung $\Delta U_{max}$ wird als Differenzspannung $\Delta U$ in der dritten Formel genutzt. Die Differenzspannung $\Delta U$ ist somit eine maximale Spannungsänderung, die sich aus einem maximalen Entladestrom des Energiespeichers ergibt.

Nach dem ersten Erkennungsschritt S3, dem zweiten Erkennungsschritt S4 oder dem dritten Erkennungsschritt S5 wird jeweils der erste Schritt S1 erneut ausgeführt und das Verfahren somit in einer Schleife wiederholt.

Es wird darauf hingewiesen, dass die erste Spannung $U_{n-1}$, welche bei einem Durchlauf des Verfahrens erfasst wird, die zweite Spannung $U_n$ aus einem vorangegangenen Durchlauf des Verfahrens sein kann. Ferner wird darauf hingewiesen, dass die Differenzspannung $\Delta U$ auch eine vorab festgelegte Konstante sein kann, die eine typische Differenzspannung beschreibt. Diese kann beispielsweise basierend auf einem für die Batteriezelle 2 typischen maximalen Entladestrom ermittelt werden.

Eine zweite Ausführungsform der Erfindung entspricht der ersten Ausführungsform der Erfindung. Jedoch ist in dem dritten Erkennungsschritt S5 die Differenzspannung $\Delta U$ eine zu erwartende Spannung, die sich aus einem gemessenen Entladestrom des Energiespeichers und dem Innenwiderstand $R_C$ ergibt.

So ist die Batteriespannung $U_C$ bei einem Entladen der Batteriezelle 2 gleich der Leerlaufspannung $U_{0CV}$ der Batteriezelle 2 abzüglich einer Spannung, die sich aus einem Batteriestrom $I_C$ bei dem Entladen und dem Innenwiderstand $R_C$ der Batteriezelle 2 zu diesem Zeitpunkt ergibt. Dieses Verhältnis wird in der folgenden sechsten Formel beschrieben.

$$U_C = U_{0CV} - I_C \cdot R_C \qquad (6)$$

Auch in der zweiten Ausführungsform wird ein Kurzschluss als vorliegend erkannt, wenn die zweite Spannung $U_n$ kleiner als die erste Spannung $U_{n-1}$ abzüglich einer Differenzspannung $\Delta U$ und abzüglich einer dritten Konstanten $\varepsilon 3$ ist. Dabei wird die Differenzspannung als ein Unterschied zwischen der Leerlaufspannung $U_{0CV}$ und der Batteriespannung $U_C$ betrachtet. Es wird somit in dem dritten Erkennungsschritt S5 die folgende siebte Formel auf ihre Wahrheit hin geprüft.

$$U_n \leq U_{n-1} + I_C \cdot R_C - \varepsilon 3 \qquad (7)$$

Dabei wird der Innenwiderstand $R_C$ entsprechend der ersten Ausführungsform gewählt und der Batteriestrom $I_C$ durch eine erneute Messung ermittelt. Alternativ kann für eine Bestimmung des Batteriestromes $I_C$ auch auf zuvor erfasste Messwerte zurückgegriffen werden. Die Differenzspannung $\Delta U$ ist somit eine zu erwartende Spannungsänderung ist, die sich aus einem gemessenen Entladestrom der Batteriezelle 2 ergibt.

Sowohl in der ersten als auch in der zweiten Ausführungsform wird basierend auf dem Wahrheitsgehalt von vorgegebenen Bedingungen geprüft, ob ein Kurzschluss innerhalb einer Batteriezelle 2 vorliegt. Dieses Prüfen kann sowohl durch eine analoge als auch durch eine digitale Auswertung erfolgen. So können beispielsweise alle gemessenen Spannungen und Ströme als digitale Werte einer Recheneinheit zugeführt werden und in dieser Recheneinheit eine mathematische Auswertung entsprechend der beschriebenen Formeln erfolgen. Somit würde eine software-gestützte Auswertung erfolgen.

Bei einer solchen software-gestützten Auswertung ist es unter anderem möglich, die in den zuvor beschriebenen Formeln benötigten Werte aus einer Vielzahl von Messwerten, beispielsweise durch eine Mittelwertbildung, zu extrahieren. Ferner können beispielsweise mehrere Schätzwerte für den Innenwiderstand $R_C$ ermittelt werden. Durch eine solche Einbeziehung mehrerer Messwerte und Schätzwerte wird die Zuverlässigkeit des Verfahrens erhöht.

Alternativ ist auch eine analoge Auswertung durch eine analoge Schaltung möglich, welche insbesondere auch ohne eine Softwareimplementierung auskommt. Dabei wird es unter Anderem ermöglicht, Abweichungen der Messwerte besonders schnell, und somit beispielsweise auch zwischen zwei Abtastungen durch einen Analog-Digital-Wandler, zu erfassen.

In den zuvor beschriebenen Ausführungsformen ist eine analoge Auswertung möglich. Dies ist beispielsweise durch einen Vergleich aktueller Messwerte der Zellspannung $U_C$, beispielsweise der zweiten Spannung $U_n$, und einiger zuvor erfasster Messwerte der Zellspannung $U_C$, beispielsweise der ersten Spannung $U_{n-1}$, durch einen Operationsverstärker möglich. So können die zuvor erfasster Messwerte beispielsweise über einen RC-Kreis an einen Eingang eines Operationsverstärkers angelegt werden. Überschreitet eine Differenz zwischen den Signalen einen durch die zuvor beschrieben Formeln bestimmten Schwellenwert, so wird ein Zellfehler, also ein Kurzschluss erkannt. Auch ein Schwellenwert, welcher von einem Zellstrom $I_C$ abhängig ist, kann dabei durch eine Operationsverstärkerschaltung bereitgestellt werden.

Ein Schaltkreis 1 einer bevorzugten Vorrichtung zum Erkennen eines Kurzschlusses ist in Figur 3 gezeigt. Der Schaltkreis 1 ermöglicht das Erkennen eines Kurzschlusses bei einem Entladen der Batteriezelle 2. Der Schaltkreis 1 umfasst einen Gleichrichter, der in der in Figur 3 gezeigten Schaltung durch eine Diode D gebildet ist. Der Schaltkreis 1 umfasst ferner eine Speichereinheit, die in der in Figur 3 gezeigten Schaltung durch einen Kondensator C gebildet ist. Der Schaltkreis 1 umfasst ferner einen steuerbaren Schalter T, der beispielsweise durch einen Transistor, beispielsweise einen FET, gebildet ist. Die Schaltung umfasst weitere Komponenten, wie z.B. Widerstände zur Begrenzung eines Ladestroms, welche jedoch nicht in Figur 3 dargestellt sind. Der Kondensator C ist somit über den Schalter T trennbar mit einen Ausgang der Batteriezelle 2 verbunden, welcher durch den positiven Pol und den negativen Pol der Batteriezelle 2 gebildet wird.

Ein negativer Pol der Batteriezelle 2 ist mit einer Schaltungserde 3 verbunden. Ein positiver Pol der Batteriezelle 2 ist mit einer Anode der Diode D verbunden. Der positive Pol der Batteriezelle 2 ist ferner mit einem ersten Schaltkontakt des Schalters T verbunden. Eine Kathode der Diode D ist mit einem ersten Pol des Kondensators C verbunden. Ein zweiter Schaltkontakt des Schalters T ist ebenfalls mit dem ersten Pol des Kondensators C verbunden. Der Schalter T schaltet eine elektrische Verbindung zwischen seinem ersten Schaltkontakt und seinem zweiten Schaltkontakt. Ein zweiter Pol des Kondensators C ist mit der Schaltungserde 3 verbunden.

Bei einem Laden der Batteriezelle 2 wird somit ein Speichern vergangener Spannungswerte der Zellspannung $U_C$ ermöglicht. Bei einem Laden der Batteriezelle 2 ist der Schalter T in einem offenen Zustand. Der Kondensator C wird über die Diode D geladen und hält diese Spannung als eine Kondensatorspannung $U_{CON}$ vor.

Diese Kondensatorspannung kann beispielsweise die erste Spannung $U_{n-1}$ der ersten und zweiten Ausführungsform sein. Diese wird mit der zweiten Spannung $U_n$ verglichen, welche der aktuellen Zellspannung $U_C$ über der Batteriezelle 2 entspricht. Ein solcher Vergleich erfolgt beispielsweise über einen in Figur 3 nicht gezeigten Komparator. Dabei ist jedoch ein Spannungsabfall $U_D$ über die Diode D zu berücksichtigen, da sich ein Verhältnis zwischen der Zellspannung $U_C$ über der Batteriezelle 2 zu der Kondensatorspannung $U_{CON}$ gemäß der folgenden achten Formel ergibt.

$$U_{CON} = U_C - U_D \quad (8)$$

Der Spannungsabfall $U_D$ über die Diode entspricht dabei einer Vorwärtsspannung der Diode D. Bei einem Laden der Batteriezelle 2 wird somit ein Speichern von Spannungswerten der Zellspannung $U_C$ ermöglicht, wobei dies besonders schnell und mit wenig Aufwand erfolgt. Tritt ein plötzlicher Spannungsabfall der Zellspannung $U_C$ auf, wenn der Schalter T in einem offenen Zustand ist, so beschreibt die Kondensatorspannung $U_{CON}$ einen Spannungswert der Zellspannung $U_C$ vor dem plötzlichen Spannungsabfall. Die Diode D ist somit derart verschaltet, dass diese ein Aufladen des Kondensators C mittels einer von der Batteriezelle 2 bereitgestellten Spannung ermöglicht, aber ein Entladen des Kondensators C verhindert.

Während dem Laden der Batteriezelle 2 kann die Schaltung somit genutzt werden, um einen Kurzschluss zu erkennen. Ein Kurzschluss liegt dann vor, wenn die in der folgenden neunten Formel formulierte Bedingung als wahr erkannt wird.

$$U_C \leq U_{CON} - U_D - \varepsilon \qquad (9)$$

Dabei ist die Konstante ε wiederum ein Korrekturfaktor zur Anpassung einer Messempfindlichkeit.

Während dem Entladen der Batteriezelle 2 ist der Schalter T geschlossen, um ein Entladen des Kondensators C auf die Zellspannung $U_C$ zu ermöglichen. Ein Erkennen eines Kurzschlusses während einem Entladen der Batteriezelle 2 oder während längeren Ruhezeiten der Batteriezelle ist mit der Schaltung 1 nicht möglich, ist aber dennoch kurz nach Beginn der Ruhezeit möglich.

Neben der obigen schriftlichen Offenbarung wird explizit auf die Offenbarung der Figuren 1 bis 3 verwiesen.

**Patentansprüche**

1. Verfahren zum Erkennen eines Kurzschlusses innerhalb eines Energiespeichers, umfassend:

   - Erfassen eines ersten Stromes ($I_{n-1}$), welcher durch den Energiespeicher zu einem ersten Zeitpunkt ($t_{n-1}$) fließt,
   - Erfassen einer ersten Spannung ($U_{n-1}$), welche von dem Energiespeicher zu dem ersten Zeitpunkt ($t_{n-1}$) bereitgestellt wird,
   - Erfassen eines zweiten Stromes ($I_n$), welcher durch den Energiespeicher zu einem auf den ersten Zeitpunkt ($t_{n-1}$) folgenden zweiten Zeitpunkt ($t_n$) fließt,
   - Erfassen einer zweiten Spannung ($U_n$), welche von dem Energiespeicher zu dem auf den ersten Zeitpunkt ($t_{n-1}$) folgenden zweiten Zeitpunkt ($t_n$) bereitgestellt wird,
   - Feststellen, ob der Energiespeicher sich in einem Ladezustand, einem Entladezustand oder in einem Leerlaufzustand befindet, basierend auf dem erfassten ersten Strom ($I_C$),
   - Ausführen eines ersten, zweiten oder dritten Erkennungsschrittes basierend auf dem festgestellten Ladezustand, wobei

     in dem ersten Erkennungsschritt, der ausgeführt wird, wenn der Energiespeicher sich in dem Leerlaufzustand befindet, ein Kurzschluss als vorliegend erkannt wird, wenn die zweite Spannung ($U_n$) kleiner als die erste Spannung ($U_{n-1}$), insbesondere kleiner als die erste Spannung ($U_{n-1}$) abzüglich einer ersten Konstanten ($\varepsilon_1$), ist,
     in dem zweiten Erkennungsschritt, der ausgeführt wird, wenn der Energiespeicher sich in dem Ladezustand befindet, ein Kurzschluss als vorliegend erkannt wird, wenn die zweite Spannung ($U_n$) kleiner als die erste Spannung ($U_{n-1}$), insbesondere kleiner als die erste Spannung ($U_{n-1}$) abzüglich einer zweiten Konstanten ($\varepsilon_2$), ist, und
     der dritte Erkennungsschritt, der ausgeführt wird, wenn der Energiespeicher sich in dem Entladezustand befindet, **dadurch gekennzeichnet ist, dass** ein Kurzschluss als vorliegend erkannt wird, wenn die zweite Spannung ($U_n$) kleiner als die erste Spannung ($U_{n-1}$) abzüglich einer Differenzspannung ($\Delta U$) und abzüglich einer dritten Konstanten ($\varepsilon_3$), ist, wobei ein Innenwiderstand ($R_C$) des Energiespeichers abgeschätzt wird, und die Differenzspannung ($\Delta U$) basierend auf dem Innenwiderstand ($R_C$) und der Differenz des zweiten Stromes ($I_n$) und des ersten Stromes ($I_{n-1}$) ermittelt wird.

2. Verfahren gemäß Anspruch 1, **dadurch gekennzeichnet, dass** die Differenzspannung ($\Delta U$) eine maximale Spannungsänderung ist, die sich aus einem maximalen Entladestrom des Energiespeichers ergibt.

3. Verfahren gemäß einem der vorhergehenden Ansprüche, **dadurch gekennzeichnet, dass** die Differenzspannung ($\Delta U$) eine zu erwartende Spannungsänderung ist, die sich aus einem gemessenen Entladestrom des Energiespeichers ergibt.

4. Vorrichtung, die dazu eingerichtet ist, das Verfahren gemäß einem der Ansprüche 1 bis 3 auszuführen.

5. Vorrichtung gemäß Anspruch 4, **dadurch gekennzeichnet, dass** die Vorrichtung einen Kondensator (C) umfasst, durch den die erste Spannung ($U_{n-1}$) erfasst und vorgehalten wird.

6. Vorrichtung gemäß Anspruch 5, **dadurch gekennzeichnet, dass** die Vorrichtung ein Diode (D) umfasst, die derart verschaltet ist, dass diese ein Aufladen des Kondensator (C) mittels einer von dem Energiespeicher bereitgestellten Spannung ermöglicht, aber ein Entladen des Kondensators (C) verhindert.

7. Vorrichtung gemäß einem der Ansprüche 5 oder 6, **dadurch gekennzeichnet, dass** die Vorrichtung einen Schalter umfasst, über welchen der Kondensator (C) trennbar mit einen Ausgang des Energiespeichers verbunden ist.

**Claims**

1. Method for detecting a short circuit within an energy store, comprising:

- detecting a first current ($I_{n-1}$) flowing through the energy store at a first time ($t_{n-1}$),
- detecting a first voltage ($U_{n-1}$) provided by the energy store at the first time ($t_{n-1}$),
- detecting a second current ($I_n$) flowing through the energy store at a second time (tn) subsequent to the first time ($t_{n-1}$),
- detecting a second voltage (Un) provided by the energy store at the second time (tn) subsequent to the first time ($t_{n-1}$),
- establishing whether the energy store is in a charging state, a discharging state or an idle state on the basis of the detected first current ($I_C$),
- performing a first, second or third detection step on the basis of the established charging state,

a short circuit being detected as present in the first detection step, which is performed if the energy store is in the idle state, if the second voltage (Un) is less than the first voltage ($U_{n-1}$), in particular less than the first voltage ($U_{n-1}$) minus a first constant ($\varepsilon_1$), a short circuit being detected as present in the second detection step, which is performed if the energy store is in the charging state, if the second voltage (Un) is less than the first voltage ($U_{n-1}$), in particular less than the first voltage ($U_{n-1}$) minus a second constant ($\varepsilon_2$), and the third detection step, which is performed if the energy store is in the discharging state, being **characterised in that** a short circuit is detected as present if the second voltage (Un) is less than the first voltage ($U_{n-1}$) minus a difference voltage ($\Delta U$) and minus a third constant ($\varepsilon_3$), an internal resistance ($R_C$) of the energy store being estimated, and the difference voltage ($\Delta U$) being determined on the basis of the internal resistance ($R_C$) and the difference between the second current ($I_n$) and the first current ($I_{n-1}$).

2. Method according to claim 1, **characterised in that** the difference voltage ($\Delta U$) is a maximum change in voltage resulting from a maximum discharge current of the energy store.

3. Method according to any of the preceding claims, **characterised in that** the difference voltage ($\Delta U$) is an expected change in voltage resulting from a measured discharge current of the energy store.

4. Device set up to carry out the method according to any of claims 1 to 3.

5. Device according to claim 4, **characterised in that** the device comprises a capacitor (C) which detects and holds in reserve the first voltage ($U_{n-1}$).

6. Device according to claim 5, **characterised in that** the device comprises a diode (D) which is connected in such a way that it enables charging of the capacitor (C), using a voltage provided by the energy store, but prevents discharging of the capacitor (C).

7. Device according to either claim 5 or claim 6, **characterised in that** the device comprises a switch via which the capacitor (C) is separably connected to an output of the energy store.

**Revendications**

1. Procédé de détection d'un court-circuit à l'intérieur d'un accumulateur d'énergie, comprenant les étapes consistant à :

- acquérir un premier courant ($I_{n-1}$) qui circule à travers l'accumulateur d'énergie à un premier instant ($t_{n-1}$),
- acquérir une première tension ($U_{n-1}$) qui est fournie par l'accumulateur d'énergie au premier instant ($t_{n-1}$),
- acquérir un deuxième courant ($I_n$) qui circule à travers l'accumulateur d'énergie à un deuxième instant (tn) suivant le premier instant ($t_{n-1}$),
- acquérir une deuxième tension (Un) qui est fournie par l'accumulateur d'énergie au deuxième instant (tn) suivant le premier instant ($t_{n-1}$),
- déterminer si l'accumulateur d'énergie se trouve dans un état de charge, un état de décharge ou un état de marche à vide, sur la base du premier courant ($I_c$) acquis,
- exécuter une première, une deuxième ou une troisième étape de détection sur la base de l'état de charge déterminé, dans lequel,

dans la première étape de détection, qui est exécutée lorsque l'accumulateur d'énergie se trouve dans l'état de marche à vide, un court-circuit est détecté comme étant présent lorsque la deuxième tension (Un) est inférieure à la première tension ($U_{n-1}$), en particulier inférieure à la première tension ($U_{n-1}$) moins une première constante ($\varepsilon_1$), dans la deuxième étape de détection, qui est exécutée lorsque l'accumulateur d'énergie se trouve dans l'état de charge, un court-circuit est détecté comme étant présent lorsque la deuxième tension (Un) est inférieure à la première tension ($U_{n-1}$), en particulier inférieure à la première tension ($U_{n-1}$) moins une deuxième constante

$(\varepsilon_2)$, et

la troisième étape de détection, qui est exécutée lorsque l'accumulateur d'énergie se trouve dans l'état de décharge, est **caractérisée en ce qu'**un court-circuit est détecté comme étant présent, lorsque la deuxième tension $(U_n)$ est inférieure à la première tension $(U_{n-1})$ moins une tension différentielle $(\Delta U)$ et moins une troisième constante $(\varepsilon_3)$, dans lequel une résistance interne $(R_C)$ de l'accumulateur d'énergie est estimée, et la tension différentielle $(\Delta U)$ est déterminée sur la base de la résistance interne $(R_C)$ et de la différence du deuxième courant $(I_n)$ et du premier courant $(I_{n-1})$.

2. Procédé selon la revendication 1, **caractérisé en ce que** la tension différentielle $(\Delta U)$ est une variation de tension maximale qui résulte d'un courant de décharge maximal de l'accumulateur d'énergie.

3. Procédé selon l'une des revendications précédentes, **caractérisé en ce que** la tension différentielle $(\Delta U)$ est une variation de tension attendue qui résulte d'un courant de décharge mesuré de l'accumulateur d'énergie.

4. Dispositif conçu pour mettre en œuvre le procédé selon l'une des revendications 1 à 3.

5. Dispositif selon la revendication 4, **caractérisé en ce que** le dispositif comprend un condensateur (C) au moyen duquel la première tension $(U_{n-1})$ est acquise et maintenue.

6. Dispositif selon la revendication 5, **caractérisé en ce que** le dispositif comprend une diode (D) qui est connectée de manière à permettre une charge du condensateur (C) au moyen d'une tension fournie par l'accumulateur d'énergie, mais à empêcher une décharge du condensateur (C).

7. Dispositif selon l'une des revendications 5 ou 6, **caractérisé en ce que** le dispositif comprend un commutateur par lequel le condensateur (C) est relié de manière séparable à une sortie de l'accumulateur d'énergie.

FIG. 1

EP 3 109 653 B1

# FIG. 2

# FIG. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20100188054 A
- US 20100194398 A
- US 20110148426 A
- JP 2001110457 A
- EP 1263111 A2